# EUROPEAN PATENT APPLICATION

(11) **EP 4 485 265 A1**
(43) Date of publication of application: **01.01.2025**
(21) Application number: 23182768.4
(22) Date of filing: 30.06.2023
(51) Int. Cl.: G06F 30/27, G06F 30/327, G06N 3/02

(54) **HLS OPTIMIZED HARDWARE IMPLEMENTATION USING MACHINE LEARNING**

(71) Applicant: Siemens AG Österreich, 1210 Wien (AT)
(72) Inventor: Chilku, Bekim, 1190 Wien (AT); Cech, Christian, 2483 Ebreichsdorf (AT); Fischer, Bernhard, 2122 Wolkersdorf im Weinviertel (AT); Hinterstoisser, Thomas, 2102 Bisamberg (AT); Matschnig, Martin, 3430 Tulln (AT)
(74) Representative: Siemens Patent Attorneys

(57) **Abstract**

Present invention concerns a method for training a machine learning, ML, system (200) for an automated design process. The method comprises training the ML system (200) based on a dataset, the dataset comprising a plurality of subsets, each subset comprising a representation of a high-level specification and an associated design representation.

The invention also concerns related methods and devices.

## Description

Present invention concerns the use of Machine Learning for automated design, in particular related methods and devices.

### Background of the Invention

Automated design, in particular automated design of circuitry, can require large amounts of computational resources and time. It may be beneficial to be able to evaluate the quality of potential designs as early as possible in the design process.

### Disclosure of the Invention

A problem underlying the invention consists in providing an improved technique to train a machine learning system for use in automated design, and an improved technique of utilizing a machine learning system in automated design.

The invention solves the given problem by means of subject-matter defined in enclosed independent claims. Dependent claims describe preferred embodiments.

There is disclosed a method for training a machine learning, ML, system for an automated design process. The method comprises training the ML system based on a dataset, the dataset comprising a plurality of subsets. Each subset comprises a representation of a high-level specification and an associated design representation. This allows providing a ML system that may improve selection of potential RTL models early on.

In general, the design representation of a subset may indicate a circuitry size associated to circuity implementing the high-level specification associated to the design representation. This may be a useful parametrization, e.g., allowing early-stage size optimization when using the trained model.

A representation of a high-level specification may correspond to a specification in C and/or C++ and/or System C and/or MATLAB. The desired functionality and/or algorithm/s of the design target may thus be suitably described.

There is also described a method (which may be referred to as second method) for an automated design process. The method comprises obtaining a representation of a high-level specification. The method further comprises determining a Machine Learning, ML, design representation utilizing a ML system. The representation of the high-level specification is input for the ML system. Furthermore, the ML system is and/or has been trained based on a method as described herein. The ML system thus may support early-stage optimization when performing the design process; the trained ML system may provide a good size estimation (of achievable sizes) with low processing demands.

A High-Level Synthesis, HLS, report and/or a Register-Transfer Level, RTL, representation may be determined and/or provided based on the high-level specification, e.g., as an action of the (second) method. The RTL representation may be part of the HLS report, and/or may be basis of the HLS report. The HLS report may indicate one or more metrics or parameters of a design represented by the RTL representation, in particular a size of an area of the design when it would be implemented. This may allow direct comparison, e.g., within a software suite and/or a workflow.

The (second) method may comprise determining a circuitry size indication based on an RTL representation, the RTL representation being based on the high-level specification; the RTL representation may be determined based on the original high-level specification, and/or a modified high-level specification. The ML design representation may be based on using the original high-level specification as input, or the same, or a different, modified high-level specification as the RTL representation is based on. Thus, easy comparison of potential area sizes may be achieved.

The (second) method may comprise providing a comparison between the ML design representation and an HLS report. The comparison may pertain to one or more parameters and/or metrics represents by the report and the ML design representation, in particular an area size. The comparison may for example indicate a size difference and/or size ratio, and/or another iteration with a modified (or to be modified) high-level specification may be started based on the comparison indicating a threshold size difference, and/or threshold ratio not being achieved; this may be indicated to a designer, and/or be performed automatically. Thus, easy handling of selection of an RTL model may be facilitated.

A computer program product is considered. The computer program product comprises instructions and/or program code or program code means causing processing circuitry and/or a computer system to perform a method as described herein, for example when executed by the processing circuitry and/or computer system. The computer program product may comprise one or more modules associated to each action of the method, e.g., a module for training, or a module for obtaining and a module for determining a ML design representation, and/or a module for determining an HLS report and/or a module for determining a circuitry size, and/or a module for providing a comparison.

Moreover, a computer system for automated design is proposed. The computer system is adapted for performing a method as described herein, and/or for executing a computer program product as described herein.

Furthermore, a storage medium storing a computer program product as described herein is proposed. The storage medium may comprise and/or be implemented as one or more memories and/or have different parts or components of the program product stored on different memories or media. The storage medium may be non-transitory. It may be considered that the storage medium may be computer-readable.

The automated design process may be fully automated, or be based on additional input, e.g., provided by a designer; such an input may for example used during selection of an RTL model or RTL representation, and/or for modifying a high-level specification. The design process may have a design target, which may be represented by a RTL representation, e.g., of a high-level specification. The design target generally may represent, and/or pertain to, and/or be, hardware and/or circuitry and/or integrated circuitry, in particular a FPGA and/or ASIC and/or SOC, and/or may be represented by an RTL representation. An RTL representation or RTL model may in some cases be considered an output of the design process. Generally, an RTL representation or model may indicate functional components of circuitry to implement the high-level specification. The automated design process may be an EDA process.

A high-level specification may indicate and/or define the functionality of a target, e.g., as algorithm/s. The high-level specification may be represented by a representation, e.g., in a high-level language (or a language combination). The representation may for example be in C/C++, and/or SystemC, and/or MATLAB. A high-level specification may be a representation of itself; in some cases, copies and/or modifications and/or transformations and/or reformulations (e.g., comprising reformatting) of a high-level specification may be considered representations of the high-level specification, in particular if the functionality and/or algorithm/s are maintained and/or equal.

A design representation may indicate and/or represent and/or comprise one or more metrics and/or parameters and/or a parametrization of a design, e.g., a size of an area of hardware, and/or a chip or chip arrangement, and/or integrated circuitry, (potentially) implementing the high-level representation. In particular, a size indication, e.g., of an area size, may be considered a design representation.

A ML design representation may indicate a circuitry size, and/or may pertain to a minimal and/or optimized size, and/or may indicate a target size of a design process, and/or a size for comparison whether a target size has been reached. The circuitry size may correspond to an area, or size of an area, which may correspond to the area a potential implementation. A ML design representation may generally pertain to and/or represent an optimization, e.g., an optimized area size for a (potential) design implementing the high-level specification. It may be considered that the potential design is not provided as part of a design representation, e.g., the ML system may in some cases not be adapted to provide an RTL model. In general, a ML design representation may be considered a ML report.

A computer system may comprise processing circuitry, and/or computer system and/or processing circuitry may comprise one or more computers, and/or may comprise one or more components and/or may be a distributed, e.g., interconnected via suitable communication interfaces. Different components may perform different actions, e.g., based on exchanging information via the interface/s. A computer system in general may be and/or comprise one or more computers and/or controllers and/or processing circuitries.

A ML system may be implemented in software and/or with data, and may alternatively referred to as ML model; in some cases, it may be implemented as and/or comprise hardware and/or firmware and/or associated components. A ML system may in general be adapted to obtain input, extract information based on the input and its training, and provide an output. Input may be a representation of a high-level specification, and/or output may be a ML design representation. A ML system or model may be based on, and/or comprise a neural network, and/or may be based on a machine learning approach. The ML system may be based on a regressive or linear approach. In some cases, a deep learning system may be used as ML model.

A dataset may be pre-defined and/or selected, e.g., manually or semi-manually. It may represent designs with known sizes. The training may comprise and/or be based on reinforcement learning, in which for example suitable or optimized cases are reinforced, and less suitable cases (e.g., designs with known sub-optimal sizes) may be indicated correspondingly.

The method may especially be carried out, completely or in part, by electronic execution means like a computer system. To these ends, the method may be formulated as a computer program product with program code means (e.g., instructions, which may in general be computer-readable and/or computer-executable). The above described system may comprise the computer system. Advantages or features of the method may apply to the method and vice versa.

### Brief Summary of the Enclosed Figures

The above-described properties, features and advantages of present invention as well as the way they are achieved will be made clearer and better understandable in the light of the following discussion, making reference to exemplary embodiments shown in accompanying figures, in which
- Figure 1: shows an exemplary HLS approach; and
- Figure 2: shows an exemplary ML model structure.

### Detailed Exemplary Embodiments of the Invention

Machine Learning (ML) has huge potential to solve many problems in the field of automated design, in particular Electronic Design Automation (EDA), where traditional methods require huge amount of time and resources to produce solutions. ML is a data-driven approach that extracts relevant features from an input dataset and may output them in form of probabilistic information.

One option for EDA is to use ML to derive a size of chip area usage for designed or generated hardware at an early design stage.

High-Level Synthesis (HLS) is an approach that transforms a behavioral description of high-level software components (functions) as input into Hardware Description Language (HDL) for generation of hardware components, e.g., in the context of automated design, in particular for circuitry. An input (high-level specification) can for example be written in C/C++ or SystemC or MATLAB language. In general, HLS may also be referred as C synthesis, electronic system-level synthesis, algorithmic synthesis or behavioral synthesis. HLS may be performed utilizing an HLS tool, which may refer to software and/or a software suite (a suite may in general have multiple components, which may be interfacing with each other), e.g., running on a computer system.

It may be generally considered that an automatic design may be an automatic circuity and/or electronics design, in particular design of integrated circuitry. The design may pertain to a design target, which may be hardware implementing a high-level specification and/or the functionality/ies of the high-level specification. The hardware may be represented by, and/or be integrated circuitry, in particular ASIC, or FPGA or SOC. Hardware designed by HLS may be referred to as synthesized hardware.

A process of HDL generation may start with building a Data Flow Graph (DFG) that may include all the operations defined in the high-level source code/specification. In a next step, derived operations from DFG may be mapped onto hardware resources. This step is known as resource allocation. A further step, known as scheduling, may add the time component to the design. An HLS tool may comprise modules for such steps or actions.

An HLS tool may also provide an option and/or module and/or component for architectural optimization, e.g., by unrolling and/or pipelining a loop design. Loop optimization may be a mechanism in HLS approach for moving data in and out of the synthesized algorithm. Loop unrolling may define the level of parallelism by replicating the same hardware used for single loop iteration, while loop pipelining may define the width in clock cycle between two loop iterations.

Although both techniques can help optimizing the performance and the size of the synthesized (designed) hardware, the style on how the algorithm is written may have an important impact on the performance and the area of the synthesized hardware. A well written algorithm that is HLS driven provides best HDL output for synthesis which reflects also on the size of the hardware layout area. From optimization perspective, a small size (in particular in area) of a design target may be preferable. An HDL output may for example represent an RTL (Register-Transfer Level) output or report. Based on such a report, a design may be implemented in hardware.

To achieve required area design constraints, a designer may iterate the high-level algorithms/specification with different design modifications, until redefined constraints are satisfied. Such an approach may consume a lot of time and cost, but there is not necessarily any indication whether the designer can reach the required constraints through repeated iterations. Furthermore, having no estimation on utilized chip area at an early design stage may make the selection of the target device difficult.

An ML system or model is proposed. The ML system or model may take the algorithms written in high-level code (referred to as high-level specification) as input, and may output a report on area size that the synthesized hardware may utilize; the area size may be optimized. A comparison between a report on hardware area from the HLS tool/design with the one from the ML model may provide an indication how far the solution derived using the HLS tool deviates from an optimal solution that can be reached, as indicated by the ML report. Next to finding an approximate minimal hardware area size, the ML model may also support a designer when on selecting the optimal hardware board for implementation.

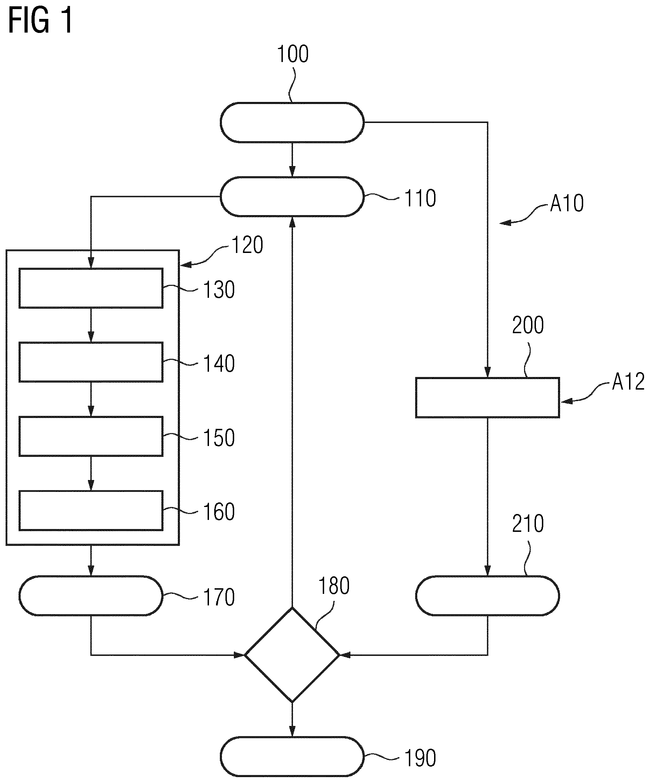

Figure 1 shows an example process of RTL model generation with an HLS tool. A processing flow starts with obtaining a high-level specification 100, e.g., high-level algorithm/s written in C\C++ or SystemC or MATLAB. On the left side of Figure 1, processes are shown through which the high-level code/specification 100 passes for the generation of an RTL model file (or report) 170, e.g., written in VHDL/Verilog.

Generating code directly from algorithm written for a CPU may be disadvantageous. Therefore, code modifications may be performed by a code modifier. Modifications may be HLS driven, but without changing the functionality of the algorithm/s. This may optimize the high-level specification for the HLS tool, e.g., in terms of format and/or structure; a modified high-level specification 110 may be provided; in particular in a first iteration, modification may be omitted, e.g., to provide the original high-level specification.

The high-level specification 100, and/or the modified specification 110 may be provided as input for an HLS tool 120. The HLS tool 120 may comprise a component 130 providing a Data Flow Graph (DFG), and/or a component 140 providing a resource allocation, and/or a component 150 providing scheduling. In some cases, the HLS tool 120 may comprise one or more components (not shown) for architectural optimization. The HLS tool 120 may comprise a component 160 outputting an RTL representation or RTL model of the high-level specification 100 provided as input. The RTL representation may be part of, and/or represent an HLS report 170, which may be output by the HLS tool 120. The RTL model and/or HLS report 170 and/or output may be provided to a model selection functionality or component 180. Selection component 180 may provide a selection, e.g., such that a designer may determine or select whether to further use the provided RTL model as resulting or selected RTL model 190, or whether to perform an additional iteration with a (e.g., further) modified high-level specification 110; automated selection functionality may be considered. A selected RTL model 190 may be basis for a design implementation, e.g., in hardware.

It is proposed to use a ML system or model 200, which may receive the high-level specification 100 as input, which may be considered an action A10 of obtaining a representation of the high-level specification.

The ML system or model may provide as output an ML report 210, which may indicate a size of an area of the design target (e.g., chip area or circuitry area), which may be an estimated area size of the design target, determined based on the high-level specification. Determining the output and/or ML report and/or the size may be considered an action A12 of determining a ML design representation.

The estimated area size may represent, and/or be assumed to represent, a minimum and/optimum area size. Selection 180 may consider a size associated to the RTL model provided by the HLS tool 120 in comparison to the size according to the ML report 210. Comparison and/or selection may be automated, e.g., based on a threshold size difference and/or ratio.

The HLS tool 120 generates the RTL model and an HLS report 170, which may comprise the model and/or refer to it, and/or may comprise different parameters related to the RTL model. In particular, the HLS report 170 may indicate the size of the area that will be utilized by the generated hardware.

It is generally proposed, as shown on the right side of Figure 1, using a trained ML model or system 200. The model 200 takes as input a representation of the high-level specification 100, e.g., a high-level code, and may generate a report on the optimal chip area size that an RTL model based on the same high-level specification 100 may reach. If the output provided by the HLS tool 120 is far from the output of the ML model, the designer may go back to the HLS-driven code to modify it even further.

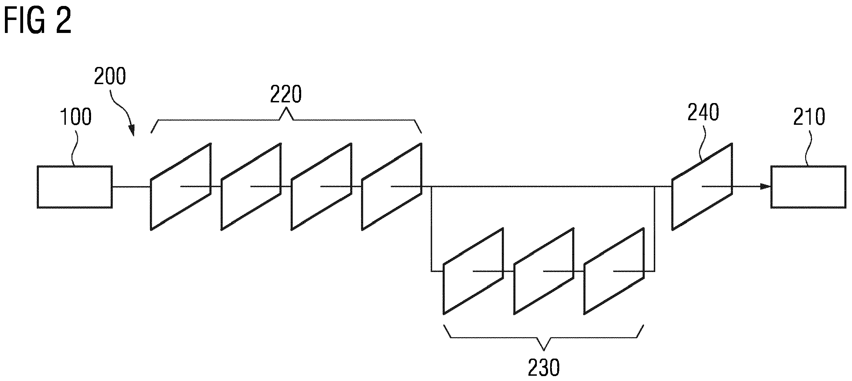

Figure 2 shows an example architecture of a ML model or system 200. The ML model 200 may be a ML regression model for hardware area estimation; in some cases, a linear model may be used. The ML model 200 may in general comprise multiple layers. A representation of the high-level specification 100 is provided as input. Extraction layers 220 of the model 200 are used to extract information on the operation derived from the high-level code and the size of the hardware components that would represent them. Optimization layers 230 take as input the outcome from blue layers and optimize the hardware area size that can be consumed, e.g., by each component needed for the design; this may be based on observing them in a holistic way. A merger layer 240 may merge the results and may provide a range for the area size of the hardware components that would be generated with HLS tool.

The implementation of this model 200 may be based on three steps:
- Generation of the dataset - Such a dataset may be collected from a set of benchmarks where the code (high-level specification) is written in a way which enables the HDL compiler to transform it into an as most as possible optimized HDL code. The dataset may comprise subsets of representations of high-level specifications and associated sizes, e.g., based on benchmarks. Benchmarks may for example represent design considered to have acceptable and/or optimized area sizes.
- Training of the model - The estimation of the ML model's metrics may be done during this step. A set of appropriate parameters from the generated dataset are used for training of the ML model. The larger part of the data set may be used for training, while the rest of the dataset, or a separate testing dataset, may be used for testing the model.
- Running the model - The ML model 200 may be part of HLS; it may be used in parallel with the HLS tool 120 to estimate the hardware area of the algorithms. In general, the ML model may operate on the high-level specification 100, in which case it may be sufficient to utilize to run it once for each design process. It may be considered, however, to run it on different iterations, e.g., on modified specifications 110, e.g., for each iteration.

Proposed approaches may facilitate providing an indication to the hardware designer on how far optimization of the hardware against the utilized hardware area may be pushed during design. An indication which requirements are needed for a hardware board that can be used for implementation may be provided to the hardware designer at a very early stage of design.

In general, circuitry may comprise integrated circuitry. Integrated circuitry or processing circuitry may comprise one or more processors and/or controllers (e.g., microcontrollers), and/or ASICs (Application Specific Integrated Circuitry) and/or FPGAs (Field Programmable Gate Array) and/or SOCs (System-on-a- Chip), or similar. It may be considered that processing circuitry comprises, and/or is (operatively) connected or connectable to one or more memories or memory arrangements or storage media, which may be non-transitory. A storage medium or memory arrangement may comprise one or more memories. A memory may be adapted to store digital information. Examples for memories comprise volatile and non-volatile and/or non-transitory memory, and/or Random Access Memory (RAM), and/or Read-Only-Memory (ROM), and/or magnetic and/or optical memory, and/or flash memory, and/or hard disk memory, and/or EPROM or EEPROM (Erasable Programmable ROM or Electrically Erasable Programmable ROM). Integrated circuitry may in general provide a set of instructions; the instructions provided may be called and/or used, and/or be available for calling and/or using, e.g., when executing an application and/or processing input, e.g., to provide an output.

Even though present invention has been illustrated and explained in detail above with reference to the preferred embodiments, the invention is not to be construed as limited to the given examples. Variants or alternate combinations of features given in different embodiments may be derived by a subject matter expert without exceeding the scope of present invention.

Independent of the grammatical term usage, individuals with male, female or other gender identities are included within the term.

### Reference List

- 100: high-level specification
- 110: modified high-level specification
- 120: HLS tool
- 130: DFG component
- 140: Resource allocation component
- 150: Scheduling component
- 160: RTL model component
- 170: HLS report
- 180: RTL model selection
- 190: RTL model (selected)

- 200: ML system/ML model
- 210: ML report or ML design representation
- 220: extraction layers
- 230: optimization layers
- 240: merger layer

## Claims

1. Method for training a machine learning, ML, system (200) for an automated design process, the method comprising:
- training the ML system (200) based on a dataset, the dataset comprising a plurality of subsets, each subset comprising a representation of a high-level specification and an associated design representation.

2. Method according to claim 1, wherein the design representation of a subset indicates a circuitry size associated to circuity implementing the high-level specification associated to the design representation.

3. Method according to one of the preceding claims, wherein the representation of a high-level specification corresponds to a specification in C and/or C++ and/or System C and/or MATLAB.

4. Method for an automated design process, the method comprising:
- obtaining (A10) a representation of a high-level specification (100, 110);
- determining (A12) a Machine Learning, ML, design representation (210) utilizing a ML system (200), wherein the representation of the high-level specification (100, 110) is input for the ML system (200), the ML system (200) being trained based on the method of one of the preceding claims.

5. Method according to claim 4, wherein the method comprises determining a High-Level Synthesis, HLS, report (170) and/or a Register-Transfer Level, RTL, representation based on the high-level specification (100, 110).

6. Method according to claim 4 or 5, wherein the method comprises determining a circuitry size indication based on an RTL representation, the RTL representation being based on the high-level specification (100, 110).

7. Method according to one of claims 4 to 6, wherein the method comprises providing a comparison between the ML design representation (210) and an HLS report (170).

8. Computer program product comprising instructions causing processing circuitry and/or a computer system to perform a method according to one of claims 1 to 7.

9. Computer system for automated design, the computer system being adapted for performing a method according to one of claims 1 to 7.

10. Storage medium storing a computer program product according to claim 8.
